Europäisches Patentamt

European Patent Office

Office européen des brevets

(19)

(11) **EP 0 943 964 A1**

(12) **EUROPÄISCHE PATENTANMELDUNG**

(43) Veröffentlichungstag:
**22.09.1999 Patentblatt 1999/38**

(51) Int. Cl.$^6$: **G03F 7/32**

(21) Anmeldenummer: 99105312.5

(22) Anmeldetag: **16.03.1999**

(84) Benannte Vertragsstaaten:
**AT BE CH CY DE DK ES FI FR GB GR IE IT LI LU
MC NL PT SE**
Benannte Erstreckungsstaaten:
**AL LT LV MK RO SI**

(30) Priorität: **16.03.1998 DE 19811331**

(71) Anmelder:
**DU PONT DE NEMOURS (DEUTSCHLAND)
GMBH
61352 Bad Homburg (DE)**

(72) Erfinder:
• **Kraska, Ursula Dr.
64331 Weiterstadt (DE)**
• **Osowski, Rudolf Dr.
63303 Dreieich (DE)**

(54) **Entwickler und Verfahren zur Herstellung von flexographischen Druckformen**

(57) Es werden ein wäßriger Entwickler für photopolymerisierbare flexographische Druckplatten enthaltend eine Kombination aus einem Aminoalkohol
und/oder einer Aminocarbonsäure und einem Netzmittel oder eine Kombination zweier Netzmittel und ein Verfahren zur Herstellung von flexographischen
Druckformen unter Verwendung dieses Entwicklers
beschrieben.

EP 0 943 964 A1

**Beschreibung**

Die Erfindung betrifft einen wäßrigen Entwickler und ein Verfahren zur Herstellung von flexographischen Druckformen durch bildmäßiges Belichten eines Aufzeichnungsmaterials, Auswaschen der unvernetzten Schichtanteile mit dem speziellen wäßrigen Entwickler und Trocknen des so behandelten Aufzeichnungsmaterials.

Es ist bekannt, für die Herstellung von flexographischen Druckformen photopolymerisierbare Druckplatten zu verwenden, bei denen die Druckoberfläche durch bildmäßiges Belichten einer durch aktinische Strahlung photopolymerisierbaren Schicht und anschließendes Entfernen der unbelichteten, nicht photopolymerisierten Druckplattenbereiche erzeugt wird. Als Entwicklerlösemittel werden hierbei üblicherweise je nach Bindemittel wäßrige Lösungen oder organische Lösemittel verwendet.

Wegen der geringeren Umweltbelastung und verminderten Gesundheitsgefährdung werden in den letzten Jahren mehr und mehr wäßrige Entwickler eingesetzt. Als wäßrige Entwickler werden z. B. wäßrige Lösungen von Alkalimetallhydroxiden oder -carbonaten und auch wäßrige Lösungen von ionischen oder nicht ionischen Netzmitteln verwendet. Netzmittel enthaltende Entwickler sind in der JP6-297829 beschrieben.

Der Auswaschprozeß wird meist in Auswaschgeräten mit rotierenden Bürsten aus unterschiedlichen Materialien durchgeführt. Netzmittelhaltige Entwickler zeigen hierbei oft eine geringe Auswaschrate.

Aufgabe der vorliegenden Erfindung war es daher, den Auswaschprozeß wäßrig entwickelbarer Flexodruckplatten zu verbessern, wobei insbesondere die Auswaschrate erhöht werden sollte.

Diese Aufgabe wird gelöst durch einen wäßrigen Entwickler für photopolymerisierbare flexographische Druckplatten, enthaltend a) eine Kombination aus mindestens einem Aminoalkohol und/oder mindestens einer Aminocarbonsäure mit mindestens einem Netzmittel oder b) eine Kombination aus mindestens zwei Netzmitteln, und einem Verfahren zur Herstellung von flexographischen Druckformen unter Verwendung dieses Entwicklers.

Überraschenderweise führt der erfindungsgemäße Entwickler zu wesentlich höheren Auswaschraten als herkömmliche Entwickler, die nur ein Netzmittel enthalten. Dieser Vorteil des erfindungsgemäßen Entwicklers war umso überraschender als aus der JP6-297829 bekannt war, daß Aminoalkohole keinen Einfluß auf die Auswaschrate zeigen sollen.

Als erfindungswesentliche Komponenten enthält der vorliegende wäßrige Entwickler mindestens einen Aminoalkohol bzw. mindestens eine Aminocarbonsäure in Kombination mit einem Netzmittel. Geeignete Aminoalkohole können sowohl eine als auch mehrere Aminogruppen und auch eine oder mehrere Hydroxygruppen enthalten. Geeignete Aminocarbonsäuren können sowohl eine als auch mehrere Aminogruppen und auch eine oder mehrere Carboxygruppen enthalten. Bevorzugt werden Aminoalkohole und Aminocarbonsäuren der Formel $R^1_xR^2_yR^3_zN$ verwendet, mit $R^1$ = H; $R^2$ = $-C_nH_{2n+1-m}-(OH)_m$ für die Aminoalkohole bzw. $-C_nH_{2n+1-m}-(COOH)_m$ für die Aminocarbonsäuren; $R^3$ = Alkyl-, Aryl-, substituierte Alkyl- oder substituierte Arylgruppen; x=0-3; y=1-3; z=0-2, n=1-15, m=n-1 und x+y+z=3 . Geeignete Aminoalkohole sind z. B. 1-Amino-2-propanol, 2-Amino-2-ethyl-1,3-propandiol, N-Butyldiethanol, Triethanolamin, 3-Diethylamino-1,2-propandiol, 2-Amino-2-methyl-1-propanol, 2(N-Benzyl-N-methylamino)ethanol, 2-Amino-1-phenyl-1,3-propandiol, 2-(2-Aminoethyl-amino)ethanol, Diisopropylamino-1,2-propandiol und Tris(hydroxymethyl)aminomethan. Insbesondere Triethanolamin, 3-Diethylamino-1,2-propandiol und Tris(hydroxymethyl)aminomethan werden bevorzugt eingesetzt. Als Aminocarbonsäuren werden bevorzugt Nitrilotriessigsäure, Serin, Asparaginsäure und auch Polyasparaginsäure eingesetzt. Die Menge der Aminoalkohole bzw. Aminocarbonsäuren betragt bevorzugt 0,05 bis 2,0 Gew.-%, insbesondere 0,1 bis 1,0 Gew.-%.

Die Menge der Netzmittel beträgt 0,1 bis 5 Gew.-%, bevorzugt 0,1 bis 2 Gew.-%. Alle bekannten nichtionischen und ionischen (anionischen, kationischen und amphoteren) Netzmittel sind im Sinne der Erfindung zu verwenden, sowohl in Kombination mit Aminoalkoholen bzw. Aminocarbonsäuren als auch in Kombinationen miteinander. Geeignete Netzmittel sind z. B. Natriumdodecylbenzolsulfonat, Natriumlaurylsulfat, Natrium 2-Etylhexylsulfat, Ethylendiamintriacetatkokosalkylacetamid Trinatriumsalz, Diisooctylsulfosuccinat Natriumsalz, Tricarboxymethyldiaminoalkylamid, Lanolinpolyglycolether, Natriumlaurylsulfat, Phenolpolyglycolether, amphotere Glycinderivate und Polyoxyethylen Glycerol Oleoricinolate. Insbesondere Ethylendiamintriacetat-kokosalkylacetamid Trinatriumsalz, Diisooctylsulfosuccinat Natriumsalz, Natriumlaurylsulfat und Polyoxyethylen Glycerol Oleoricinolate werden bevorzugt verwendet. Der vorliegende wässrige Entwickler kann auch eine Kombination von mindestens zweien der oben beschriebenen Netzmitteln in wässriger Lösung enthalten.

Der vorliegende Entwickler wird durch Auflösen der entsprechenden Mengen der zu verwendenden Komponenten in Wasser vor dem Entwicklungsprozess hergestellt. Der Entwickler der vorliegenden Erfindung kann in allen herkömmlichen Auswaschgeräten, bevorzugt in Edelstahlgeräten, verwendet werden. Alle gängigen Bürstenmaterialien, wie z.B. Nylon, Polyester oder Polypropylen, können eingesetzt werden. Der Auswaschprozess wird bevorzugt bei erhöhter Temperatur durchgeführt, üblicherweise bei ≥ 30 °C, insbesondere bei 50 °C.

Der vorliegende Entwickler eignet sich für die Entwicklung von wäßrig entwickelbaren Aufzeichnungsmaterialien mit photopolymerisierbaren Schichten.

Bevorzugt enthalten diese Schichten hydrophile Polymere, ggf. hydrophobe Polymere, photopolymerisierbare Monomere, Photoinitiatoren und weitere Hilfsstoffe wie Weichmacher, Füllstoffe, Stabilisatoren, Farbstoffe, Inhibitoren, etc.

Als wesentliche Bindemittel enthalten wäßrig entwickelbare Druckplatten Polymere mit hydrophilen Gruppen wie z. B. Hydroxyl-, Carboxyl-, Amino-, Nitril-, Schwefelsäureester- und Phosphorsäureestergruppen oder auch Kombinationen dieser Gruppen, genannt seien z. B. Polyvinylalkohole, Polyvinylacetate, Copolymere aus (Meth)acrylsäure und (Meth)acrylaten, Cellulosederivate, Polyester, Polyamide, carboxylierte Butadien-Acrylnitrilpolymere, Core-Shell-Polymere mit hydrophilen Gruppen in den Shell-Polymeren oder Blockcopolymere mit hydrophoben und hydrophilen Blöcken. Auch Gemische verschiedener dieser Polymere werden verwendet oder Gemische mit hydrophoben Bindemitteln wie thermoplastisch elastomere Copolymeren, insbesondere mit thermoplastisch elastomeren Blockcopolymeren. Bevorzugt werden lineare und radiale Polystyrol-Polybutadien-Polystyrol- bzw. Polystyrol-Polyisopren-Polystyrol-Blockcopolymere verwendet. Wäßrig entwickelbare Flexodruckplatten sind z. B. in US 5,175,076; EP-A 0 784 232; US 4,621,044; US 4,177,074; und US 5,075,192 beschrieben.

Die photopolymerisierbaren Materialien können nach gängigen Methoden auf handelsübliche Trägermaterialien aufgebracht und bildmäßig belichtet werden. Nach der Entwicklung mit den erfindungsgemäßen Entwicklern erfolgt die Trocknung der Druckformen, woran ggf. eine chemische Nachbehandlung und/oder Druckformen, woran ggf. eine chemische Nachbehandlung und/oder eine Nachbelichtung angeschlossen werden kann.

Die folgenden Beispiele sollen die vorliegende Erfindung verdeutlichen. Die angegebenen Teile und Prozente beziehen sich, falls nichts anderes angegeben ist, auf das Gewicht.

Beispiele und Vergleichsversuche

In den folgenden Beispielen und Vergleichsbeispielen wurde die Auswaschzeit durch Bestimmung der Relieftiefen nach 10 min Auswaschzeit bestimmt. Mit jedem Entwickler wurden mindestens zwei Flexodruckplatten ausgewaschen, das Relief jeweils an vier Meßpunkten ermittelt und für des Ergebnis der Mittelwert gebildet.

Es wurden handelsübliche wäßrig auswaschbare Cyrel® AQS Flexodruckplatten (z.B. 2,90 mm bzw. 1,70 mm Dicke) verwendet. Auf eine solche Flexodruckplatte wurde in einem Röhrenbelichter (DuPont Cyrel® 3038 E- 60 sec = 650 mJ/cm$^2$) ein Rahmen aufbelichtet. Anschließend wurde das unbelichtete Druckplattenmaterial in einem Laborgerät mit fest montierten Bürsten durch Rotieren der Flexodruckplatte bei 50° C mit den zu untersuchenden wäßrigen Entwicklern ausgewaschen.

Vergleichsbeispiel 1

Als Entwickler wurde eine Lösung (voll entsalztes Wasser) von 0,5 % Ethylendiamintriacetat-kokosalkylacetamid Trinatriumsalz (CAS-Nr. 93 165-97-0) eingesetzt. Die Relieftiefe betrug 0,561 mm.

Beispiel 1

Als Entwickler wurde eine Lösung (voll entsalztes Wasser) von 0,5 % Ethylendiamintriacetat-kokosalkylacetamid trinatriumsalz (CAS-Nr. 93 165-97-0) und a) 0,5 % Triethanolamin, b) 0,5 % Tris(hydroxymethyl)aminomethan und c) 0,25 % 3-Diethylamino-1,2-propandiol eingesetzt. Die Relieftiefen betrugen: a) 1,053 mm; b) 1,037 mm und c) 1,747 mm. Dies entspricht einer Steigerung der Waschleistung gegenüber dem Vergleichsbeispiel 1 um: a) 88 %, b) 85 % und c) 211 %.

Beispiel 2

Als Entwickler wurde eine Lösung (voll entsalztes Wasser) von 0,5 % Ethylendiamintriacetat-kokosalkylacetamid Trinatriumsalz (CAS-Nr. 93 165-97-0) und 0,5 % Nitrilotriessigsäure eingesetzt. Die Relieftiefe betrug 0,840 mm. Dies entspricht einer Steigerung der Waschleistung gegenüber dem Vergleichsbeispiel 1 um 50 %

Vergleichsbeispiel 2

Als Entwickler wurde eine Lösung (voll entsalztes Wasser) von 0,5 % Natriumlaurylsulfat eingesetzt. Die Relieftiefe betrug 0,616 mm.

Beispiel 3

Als Entwickler wurde eine Lösung (voll entsalztes Wasser) von 0,5 % Natriumlaurylsulfat und 0,5 % Tris(hydroxymethyl)aminomethan eingesetzt. Die Relieftiefe betrug 1,126 mm. Dies entspricht einer Steigerung der Waschleistung gegenüber dem Vergleichsbeispiel 2 um 83 %.

Vergleichsbeispiel 3

Als Entwickler wurde eine Lösung (voll entsalztes Wasser) von 0,5 % Tegotens® V20 der Firma Goldschmidt (ein Netzmittel vom Typ Polyoxyethylen Glycerol Oleoricinolat) eingesetzt. Die Relieftiefe betrug 0,688 mm.

Beispiel 4

Als Entwickler wurde eine Lösung (voll entsalztes Wasser) von 0,5 % Tegotens® V20 der Firma Goldschmidt (ein Netzmittel vom Typ Polyoxyethylen Glycerol Oleoricinolat) und 0,2 % 3-Diethylamino-1,2-propandiol eingesetzt. Die Relieftiefe betrug 1,070 mm. Dies entspricht einer Steigerung der Waschleistung gegenüber dem Vergleichsbeispiel 3 um 55 %.

Vergleichsbeispiel 4

Als Entwickler wurde eine Lösung (voll entsalztes Wasser) von 1,0 % Natriumlaurylsulfat eingesetzt (pH-Wert der Lösung: 8,3). Die Relieftiefe betrug 0,680 mm.

Vergleichsbeispiel 5

Als Entwickler wurde eine Lösung (voll entsalztes Wasser) von 1,0 % Ethylendiamintriacetat-kokosalkylacetamid Trinatriumsalz (CAS-Nr. 93 165-97-0) (pH-Wert der Lösung: 11,0) eingesetzt. Die Relieftiefe betrug 0,660 mm.

Vergleichsbeispiel 6

Als Entwickler wurde eine Lösung (voll entsalztes Wasser) von 1,0 % des Natriumsalzes von Diisooctylsulfosuccinat (pH-Wert der Lösung: 8,3) eingesetzt. Die Relieftiefe betrug 0,525 mm.

Beispiel 5

Als Entwickler wurde eine Lösung (voll entsalztes Wasser) von 0,5 % Natriumlaurylsulfat und 0,5 % Ethylendiamintriacetatkokosalkylacetamid Trinatriumsalz (CAS-Nr. 93 165-97-0) (pH-Wert der Lösung: 11,0) eingesetzt. Die Relieftiefe betrug 0,780 mm. Dies entspricht einer Steigerung der Waschleistung gegenüber Vergleichsbeispiel 4 um 15 % und gegenüber Vergleichsbeispiel 5 um 18 %.

Beispiel 6

Als Entwickler wurde eine Lösung (voll entsalztes Wasser) von 0,5 % Natriumlaurylsulfat und 0,5 % des Natriumsalzes von Diisooctylsulfosuccinat (pH-Wert der Lösung: 7,3) eingesetzt. Die Relieftiefe betrug 0,820 mm. Dies entspricht einer Steigerung der Waschleistung gegenüber Vergleichsbeispiel 4 um 21 % und gegenüber Vergleichsbeispiel 6 um 56 %.

Beispiel 7

Als Entwickler wurde eine Lösung (voll entsalztes Wasser) von 0,3 % Natriumlaurylsulfat, 0,3 % Ethylendiamintriacetatkokosalkylacetamid Trinatriumsalz (CAS-Nr. 93 165-97-0) und 0,3 % des Natriumsalzes von Diisooctylsulfosuccinat (pH-Wert der Lösung: 10,6) eingesetzt. Die Relieftiefe betrug 0,775 mm. Dies entspricht einer Steigerung der Waschleistung gegenüber Vergleichsbeispiel 4 um 14 %, gegenüber Vergleichsbeispiel 5 um 17 % und gegenüber Vergleichsbeispiel 6 um 48 %.

**Patentansprüche**

1.  Wäßriger Entwickler für photopolymerisierbare flexographische Druckplatten, enthaltend

    a) eine Kombination aus mindestens einem Aminoalkohol und/oder mindestens einer Aminocarbonsäure mit mindestens einem Netzmittel oder

    b) eine Kombination aus mindestens zwei Netzmitteln.

2.  Wäßriger Entwickler gemäß Anspruch 1, dadurch gekennzeichnet, daß Aminoalkohole der Formel $R^1_x R^2_y R^3_z N$ verwendet werden, mit $R^1$ = H; $R^2$ = $-C_n H_{2n+1-m}-(OH)_m$; $R^3$ = Alkyl-, Aryl-, substituierte Alkyl- oder substituierte Arylgruppen; x=0-3; y=1-3; z=0-2, n=1-15, m=n-1 und x+y+z=3 .

3.  Wäßriger Entwickler gemäß Anspruch 1 oder 2, dadurch gekennzeichnet, daß als Aminoalkohole Triethanolamin, 3-Diethylamino-1,2-propandiol und Tris(hydroxymethyl)aminomethan verwendet werden.

4.  Wäßriger Entwickler gemäß Anspruch 1 bis 3, dadurch gekennzeichnet, daß 0,05 bis 2,0 Gew.-% des oder der Aminoalkohole enthalten sind.

5.  Wäßriger Entwickler gemäß Anspruch 1 bis 4, dadurch gekennzeichnet, daß Aminocarbonsäuren der Formel $R^1_x R^2_y R^3_z N$ verwendet werden, mit $R^1$ = H; $R^2$ = $-C_n H_{2n+1-m}-(COOH)_m$; $R^3$ = Alkyl-, Aryl-, substituierte Alkyl- oder substituierte Arylgruppen; x=0-3; y=1-3; z=0-2, n=1-15, m=n-1 und x+y+z=3 .

6.  Wäßriger Entwickler gemäß Anspruch 1 bis 5, dadurch gekennzeichnet, daß als Aminocarbonsäuren Nitrilotriessigsäure, Serin, Asparaginsäure und auch Polyasparaginsäure verwendet werden.

7.  Wäßriger Entwickler gemäß Anspruch 1 bis 6, dadurch gekennzeichnet, daß 0,05 bis 2,0 Gew.-% des oder der Aminocarbonsäuren enthalten sind.

8.  Wäßriger Entwickler gemäß Anspruch 1 bis 7, dadurch gekennzeichnet, daß 0,1 bis 5 Gew.-% des oder der Netzmittel enthalten sind.

9. Wäßriger Entwickler gemäß Anspruch 1 bis 8, dadurch gekennzeichnet, daß als Netzmittel Ethylendiamintriacetat-kokosalkylacetamid Trinatriumsalz, Diisooctylsulfosuccinat Natriumsalz, Natriumlaurylsulfat und Polyoxyethylen Glycerol Oleoricinolate verwendet werden.

10. Verfahren zur Herstellung von flexographischen Druckformen durch

   a) bildmäßiges Belichten eines Aufzeichnungsmaterials, umfassend ein Trägermaterial und mindestens eine mit aktinischer Strahlung vernetzbare Schicht, mit aktinischer Strahlung unter Vernetzung der belichteten Schichtanteile,
   b) Auswaschen der unvernetzten Schichtanteile mit einem wäßrigen Entwickler und
   c) Trocknen des so behandelten Aufzeichnungsmaterials,

   dadurch gekennzeichnet, daß ein wäßriger Entwickler gemäß einem der Ansprüche 1 bis 9 verwendet wird.

Europäisches
Patentamt

**EUROPÄISCHER RECHERCHENBERICHT**

Nummer der Anmeldung

EP 99 10 5312

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | GB 2 226 150 A (NORDISK TIDNINGSPLAT AB) 20. Juni 1990 * Seite 4, Absatz 5 * * Seite 5, Absatz 1 * * Seite 8 - Seite 10; Beispiele 2,5 * --- | 1-4,8,10 | G03F7/32 |
| X | EP 0 274 044 A (HORSELL, GRAPHIC INDUSTRIES LTD.) 13. Juli 1988 * Seite 3; Beispiel 2 * ----- | 1,5,7,8, 10 | |

RECHERCHIERTE
SACHGEBIETE (Int.Cl.6)

G03F

Der vorliegende Recherchenbericht wurde für alle Patentansprüche erstellt

| Recherchenort | Abschlußdatum der Recherche | Prüfer |
|---|---|---|
| DEN HAAG | 25. Juni 1999 | Dupart, J.-M. |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**          EP 99 10 5312

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-06-1999

| Im Recherchenbericht angeführtes Patentdokument | Datum der Veröffentlichung | Mitglied(er) der Patentfamilie | Datum der Veröffentlichung |
|---|---|---|---|
| GB 2226150 A | 20-06-1990 | KEINE | |
| EP 0274044 A | 13-07-1988 | DE 3776536 A<br>US 4945030 A | 12-03-1992<br>31-07-1990 |

EPO FORM P0461

Für nähere Einzelheiten zu diesem Anhang : siehe Amtsblatt des Europäischen Patentamts, Nr.12/82